# EUROPÄISCHE PATENTANMELDUNG

(11) **EP 2 101 113 A2**
(43) Veröffentlichungstag der Anmeldung: **16.09.2009**
(21) Anmeldenummer: 09164483.1
(22) Anmeldetag: 19.05.2005
(51) Int. Cl.: F24C 7/08, H03K 17/96

(54) **Sensoranordnung für eine pseudo-kontinuierliche Betätigung**

(30) Priorität: 19.05.2004 DE 102004024835
(62) Teilanmeldung aus: 05010870.3
(71) Anmelder: ZF Friedrichshafen AG, 88038 Friedrichshafen (DE)
(72) Erfinder: Türmer, Hubert, 91275 Auerbach (DE); Habenschaden, Josef, 92702 Kohlberg (DE)

(57) **Zusammenfassung**

Bei einer Kochfeldsteuerung ist eine Mehrzahl von Infrarotsensoren längs einer Bedienlinie angeordnet. Während die Fototransistoren die eigentliche Bedienlinie bilden, ist eine Mehrzahl von Infrarotsendedioden, die nicht unbedingt mit der Mehrzahl von Infrarotfototransistoren übereinstimmen muss, in deren Nachbarschaft angeordnet. Die Infrarotsendedioden bzw. deren Lichtleiter nehmen eine vorgegebene Winkelstellung relativ zu der Bedienlinie der Fototransistoren ein.

## Beschreibung

Die Erfindung bezieht sich auf eine Kochfeldsteuerung mit einer Mehrzahl von Infrarot-Sensoren, die längs einer Bedienlinie angeordnet sind.

Aus der Offenlegungsschrift DE 102 11 047 A1 ist eine Anordnung zum Steuern eines Kochfeldes bekannt. Das Bedienfeld weist neben einem Hauptschalter vier Infrarot-Berührungsschalter auf, die zum Einstellen der Leistungsstufe an vier verschiedenen Kochstellen der zugehörigen Kochplatte dienen. Dabei ist jeder Kochstelle einer der Infrarot-Berührungschalter zugeordnet. Jeder der Berührungsschalter weist zwei Sensoren auf. Wenn der Nutzer den Sensor "Minus" berührt, so wird die Leistungsstufe der Kochstelle heruntergeschaltet. Wenn der Nutzer hingegen den Sensor "Plus" des Berührungsschalters berührt, so wird die Leistungsstufe hochgefahren. Jeder Infrarotsensor besteht aus einer Infrarotsendediode und einem Infrarotfototransistor.

Eine ähnliche Steuerungsbaugruppe gemäß der Gebrauchsmusterschrift DE 200 08 425 U1 weist für vier Herdplatten mindestens zehn Sensorelemente auf. Zum Erhöhen und Erniedrigen der Kochstufe einer Kochstelle sind -wie bei dem zuvor erwähnten Stand der Technik- jeweils Sensorelemente "Plus" und "Minus" vorgesehen. Jedes Sensorelement besteht aus einem Infrarot-Sender und einem für Infrarotlicht empfindlichen Empfänger, die auf einer Leiterplatte benachbart befestigt sind. Zur optischen Abschottung der mindestens zehn Sensorelemente voneinander dienen entweder einzelne Kunststoffrähmchen oder eine gemeinsame Matte.

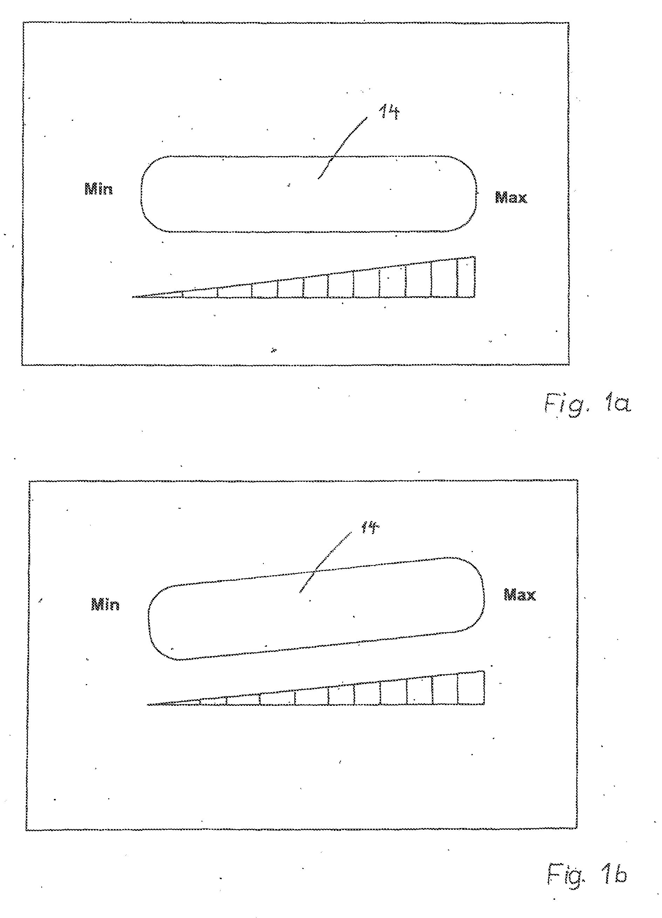

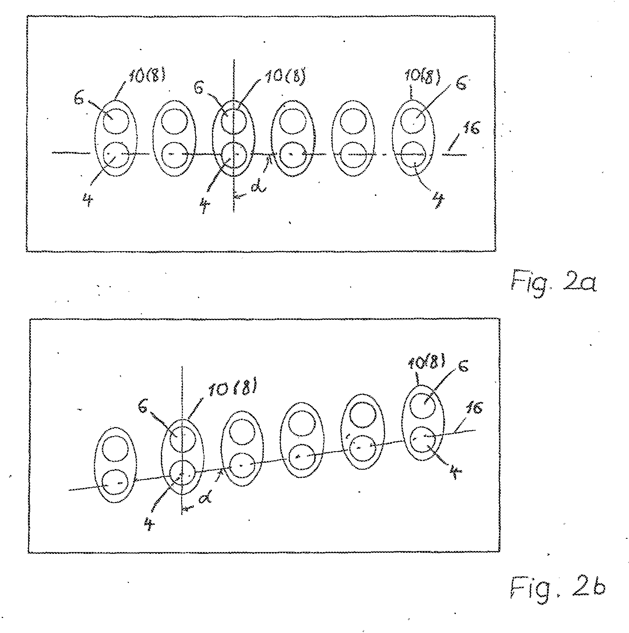

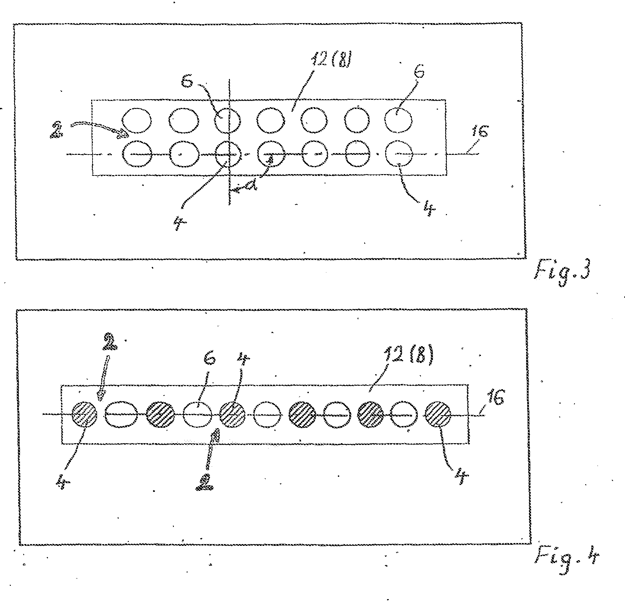

Auch die aus den Abschnitten [0001] und [0002] der Druckschrift US 2003/0090470 A1 bekannte Verwendung von Infrarot-Sensorpaaren als Einzeltasten (und die zugehörige Ausrichtung der Infrarot-Lichtsender und Infrarot-Lichtempfänger "zueinander") sind in der vorliegenden Erfindung vorausgesetzt. Die Schrift sagt hingegen nichts aus über eine Gruppierung solcher Tasten zu einer funktionalen Bedienlinie. Es geht laut Absatz [0003], [0004] und [0005] stets um ein ungestörtes Betätigen einer einzigen Taste. Diese technische Lehre propagiert eine zeitselektive Ansteuerung, um eine Mehrfachbetätigung benachbarter Sensoren zu verhindern. Bei der Bedienlinie gemäß Anspruch 2 der Erfindung ist eine Mehrfachbetätigung benachbarter Sensoren durch aus möglich, auswertbar und erwünscht. Gemäß Absatz [0022] können zwar jeweils vier Lichtsender und jeweils vier zugeordnete Lichtempfänger "längs einer Reihe" angeordnet sein. Das bedeutet jedoch nicht, dass diese vier Einzeltasten eine Bedienlinie bilden. Vielmehr geht es darum, die vier Tasten trotz eines minimalen Abstands getrennt zu berühren und zu bedienen. Eine gleichmäßige Ausrichtung der bekannten Sensorpaare würde deshalb in dem Stand der Technik gemäß US 2003/0090470 A1 keine Rolle spielen. Von einer Ausrichtung eines IR-Fototransistors und einer IR-Sendediode als Paare mit jeweils gleicher Ausrichtung relativ zu einer Bedienlinie wird nichts angedeutet. Ferner sind die Anspruchsmerkmale aus dieser Schrift auch nicht zufällig bekannt. Weder der in Figur 1 dargestellte Schnitt durch die Reihe noch das in den Figuren 2 und 3 dargestellte Schema zeigen einen Grundriss, aus dem eine Winkelausrichtung von Paarachsen relativ zu einer Bedienlinie oder relativ zu einer Reihe entnehmbar wäre. Eine solche Darstellung einer Ausrichtung wäre auch nicht notwendig: Denn wenn aufgrund der genannten zeitselektiven Ansteuerung sowieso immer nur ein Transistor-Sensor-Paar in Betrieb ist, so ist die Anordnung der Paare untereinander oder relativ zueinander ohne Bedeutung.

Auch die Schrift EP 0 618 680 A1 zeigt keine auf Infrarotlicht basierende Bedienlinie, sondern eine Dreifachtastatur. Es handelt sich um eine optoelektronische Tastatur für ein industrielles Messinstrument. Bei dieser dreifachen Abfolge isolierter Einzeltasten werden Signale auf benachbarte Tasten, anders als bei Schiebereglern, als Störsignale empfunden und deshalb eliminiert. In Fig. 2 der EP 0 618 680 A1 ist eine Halterung für IR-Lichtsender, IR-Lichtempfänger und Abschirmungen der Dreifachtastatur dargestellt. Die Halterung ist bevorzugt ein Kunststoffteil, an das die Abschirmungen der Einzeltasten untereinander als gemeinsamer Steg angeformt sind.

Aus der Offenlegungsschrift DE 196 45 907 ist eine gattungsgemäße Vorrichtung zum Einstellen des Betriebszustands eines Kochfelds bekannt. Ausgehend von den oben beschriebenen "Touch-Sensoren" wird bemängelt, dass jede Leistungsstufe immer seriell zwischen einer aktuellen Leistungsstufe und einer gewünschten Leistungsstufe durchgeschaltet werden muss. Zur Abhilfe wird vorgeschlagen, für jede Kochstelle ein Bedienfeld mit jeweils acht Betätigungssensoren zum Steuern der Heizleistung (Kochstufe) nebeneinander anzuordnen. Offenbart sind eine lineare Anordnung, die einem Schiebeschalter entspricht, und eine kreisbogenförmige Anordnung, die einem Drehknebel entspricht. Ein gewünschter Betriebszustand wird dann eingestellt, wenn beginnend mit einem vorgegebenen Betätigungssensor als Startsensor nacheinander aufeinander folgende Betätigungssensoren bis zu einem Zielsensor mit dem Finger berührt werden.

Ein ähnlicher "Stellstreifen", der ebenfalls geradlinig oder bogenförmig oder kreisförmig verlaufen kann, ist aus der Offenlegungsschrift DE 01 33 135 A1 = EP 273 851 A2 bekannt. Die berührungsempfindlichen Sensoren können auf allen bekannten Prinzipien beruhen (kapazitiv, induktiv, optisch, thermisch, piezoelektrisch oder dgl.), ohne dass die Druckschrift Angaben über eine konstruktiv zweckmäßige Anordnung von optischen Sensoren auf einem "Stellstreifen" macht. Offenbart ist ein kapazitiver Stellstreifen, bei dem ein dielektrischer Träger metallische Sensorflächen trägt. Auch die Schrift US 4,121,204 A offenbart lediglich eine Anordnung von kapazitiven Sensoren entlang einer Linie sowie eine zusätzliche Anordnung von Neonlampen entlang dieser Linie.

Ausgehend von Kochfeldsteuerungen mit einer Mehrzahl von Infrarot-sensoren, die längs einer Bedienlinie angeordnet sind, besteht die Aufgabe der Erfindung darin, die Infrarotfototransistoren und die Infrarotsendedioden konstruktiv zweckmäßig entlang der Bedienlinie anzuordnen.

Die Lösung der Aufgabe besteht gemäß Anspruch 1 darin, dass eine Mehrzahl von IR-Fototransistoren auf einer Bedienlinie angeordnet sind und eine gleich große Anzahl von IR-Sendedioden neben der Bedienlinie in der Nachbarschaft der IR-Fototransistoren so angeordnet sind, dass je ein IR-Fototransistor und eine IR-Sendediode ein Paar mit jeweils gleicher Ausrichtung relativ zu der Bedienlinie bilden.

Zweckmäßige konstruktive Weiterbildungen der Erfindung gehen aus den Unteransprüchen hervor.

Das Prinzip der Erfindung besteht darin, die Infrarotfototransistoren auf einer frei wählbaren und ergonomisch günstigen Bedienlinie anzuordnen und die Infrarotsendedioden auf der Bedienlinie oder in der Nachbarschaft der Bedienlinie so zu gruppieren, dass die Infrarotfototransistoren bei einer komplexen Fingerberührung gut ausgeleuchtet werden. Dabei müssen ein Fototransistor und eine IR-Sendediode nicht unbedingt ein festes Paar bilden. Eine schmale oder schlanke Bedienlinie wird beispielsweise erhalten, wenn die Leuchtdioden und die Fototransistoren abwechselnd auf der Bedienlinie angeordnet sind. Eine breitere Bedienlinie ergibt sich, wenn die Leuchtdioden in einem zwischen 0 und 90 Grad liegenden Winkel zur Reihung der Fototransistoren neben der Bedienlinie angeordnet sind. Um die Bediensicherheit zu erhöhen, kann in diesem Fall auch je eine Reihe von Leuchtdioden links und rechts neben der Bedienlinie angeordnet sein und jeweils ein Tripel mit einem Fototransistor bilden.

Ausführungsbeispiele der Erfindung werden anhand von Figuren 1 bis 5 erläutert. Es zeigen:
- Figur 1a: eine geradlinige, horizontale Betätigungsfläche einer erfin- dungsgemäßen Kochfeldsteuerung;
- Figur 1b: eine geradlinige, schräge Betätigungsfläche einer erfindungs- gemäßen Kochfeldsteuerung;
- Figur 2a: ein unter der Betätigungsfläche nach Figur 1a angeordnetes Gehäuse, bestehend aus mehreren Lichtleitsockeln, mit einer horizontalen Bedienlinie nach einer ersten Ausführungsform der Erfindung;
- Figur 2b: ein unter der Betätigungsfläche nach Figur 1b angeordnetes Gehäuse, bestehend aus mehreren Lichtleitsockeln, mit einer schrägen Bedienlinie nach einer zweiten Ausführungsform der Erfindung;
- Figur 3: ein unter der Betätigungsfläche nach Figur 1a angeordnetes Gehäuse nach einem dritten Ausführungsbeispiel der Erfin- dung, bei dem im Unterschied zu Figur 2a alle IR-Sensoren in einem Kunststoffteil gruppiert sind (Winkel α = 90 DEG zur Bedienlinie);
- Figur 4: ein unter der Betätigungsfläche nach Figur 1a angeordnetes Gehäuse nach einem vierten Ausführungsbeispiel der Erfin- dung, bei dem im Unterschied zu Figur 2a die Elemente in ei- nem Kunststoffteil gruppiert sind (Winkel α = 0 DEG zur Be- dienlinie);
- Figur 5a: beispielhaft eine direkte Anwahl einer Kochstufe;
- Figuren 5b und 5c: beispielhaft eine Erniedrigung der Kochstufe durch Überstreichen der Betätigungsfläche von rechts nach links.

In herkömmlichen, autarken Glaskeramikkochfeldern werden die Kochstufen der einzelnen Kochstellen meist durch so genannte Sensorschalter eingestellt. Hierbei ist eine Sensorfläche, die entsprechend auf der Glaskeramik optisch gekennzeichnet ist, durch den Benutzer zu betätigen, um entweder die Kochstufe zu erhöhen oder zu erniedrigen. Eine dauerhafte Betätigung bewirkt dabei eine kontinuierliche Veränderung der eingestellten Kochstufe z.B. von 0, 1, 2... bis 9. Nachteilig ist hierbei die lange Betätigungszeit, um von der niedrigsten zur höchsten Kochstufe und umgekehrt zu gelangen.

Zur Abhilfe wurde eine Sensoranordnung vorgeschlagen, die eine pseudokontinuierliche Betätigung ermöglicht, die einem Schieberegler nachempfunden ist. Diese Sensoranordnung wird erfindungsgemäß weiterentwickelt. Neben der Sensoranordnung wird eine Lichtleiteranordnung in einem Gehäuse definiert.

Nach einem ersten Konzept der Erfindung werden Sensorpaare 2 auf einer Bedienlinie 16 angeordnet. Jedes Sensorpaar 2 besteht dabei aus einer Infrarotsendediode 6 und einem Infrarotfototransistor 4. Die Sensorpaare 2 können dabei in unterschiedlichster Weise aufgereiht werden, z.B. waagerecht, senkrecht, schräg, halbkreisförmig, viertelkreisförmig, geschwungen usw. Je nachdem, wie viele Sensorpaare 2 nacheinander angeordnet werden, können unterschiedlich lange Betätigungsfelder 14 definiert werden. Die Länge der Betätigungsfelder 14 hängt auch vom Abstand zwischen den Sensorpaaren 2 ab.

Die Figuren 1a und 1b zeigen zwei Beispiele für eine Betätigungsflächel4. In diesen Fällen ist die Betätigungsfläche 14 geradlinig, das heißt ein Finger 18 kann zwischen den Werten MIN und MAX die Betätigungsfläche 14 geradlinig berühren. Auf einem der Betätigungsfläche 14 zugeordneten grafischen Symbol wird die nach Art eines Schiebereglers eingestellte Kochstufe angezeigt.

In Figur 1a ist die längs der Bedienlinie 16 liegende Betätigungsfläche 14 horizontal, in Figur 1b schräg ausgerichtet.

Die Figuren 2a und 2b zeigen die zugehörigen Anordnungen der Sensoren 2 in Lichtleitsockeln 10. Ein Gehäuse 8,10 enthält entweder in waagerechter Anordnung (Figur 2a) oder in schräger Anordnung (Figur 2b) eine Reihe von Infrarotsensoren 2. Jeder Infrarotsensor 2 besteht in diesem Fall (Figuren 2a und 2b) aus einem Infrarotfototransistor 4 und einer Infrarotlichtquelle 6, die in einem Lichtleitsockel 10 zu einem Paar 2 angeordnet sind. Die IR-Fototransistoren 4 liegen auf einer Bedienlinie 16 unterhalb des Betätigungsfeldes 14.

Bei den Ausführungsbeispielen gemäß den Figuren 3 und 4 sind alle Infrarotelemente 4,6 in einem Kunststoffteil 12 gruppiert, das mehrere Infrarotsendedioden 6 und Infrarotfototransistoren 4 sowie die zugehörigen Lichtleiter enthält. In beiden Fällen ist die Bedienlinie 16 eine horizontale Gerade wie in Figur 2a, jedoch sind in dem Ausführungsbeispiel gemäß Figur 3 die Infrarotsendedioden 6 und Infrarotfototransistoren 4 paarweise unter α = 90 DEG angeordnet, während in dem Ausführungsbeispiel nach Figur 4 die Infrarotsendedioden 6 um 90 DEG in die Bedienlinie 16 hineingedreht sind. In Figur 4 wechselt jeweils eine Infrarotsendediode 6 mit einem Infrarotfototransistor 4 ab. Diese Anordnung wird auf jeder Seite mit einem Infrarotfototransistor 4 abgeschlossen.

In allen Fällen kann die Bedienlinie 16 auch schräg, bogenförmig oder geschwungen sein.

Die erfindungsgemäße Kochfeldsteuerung wird wie folgt bedient.

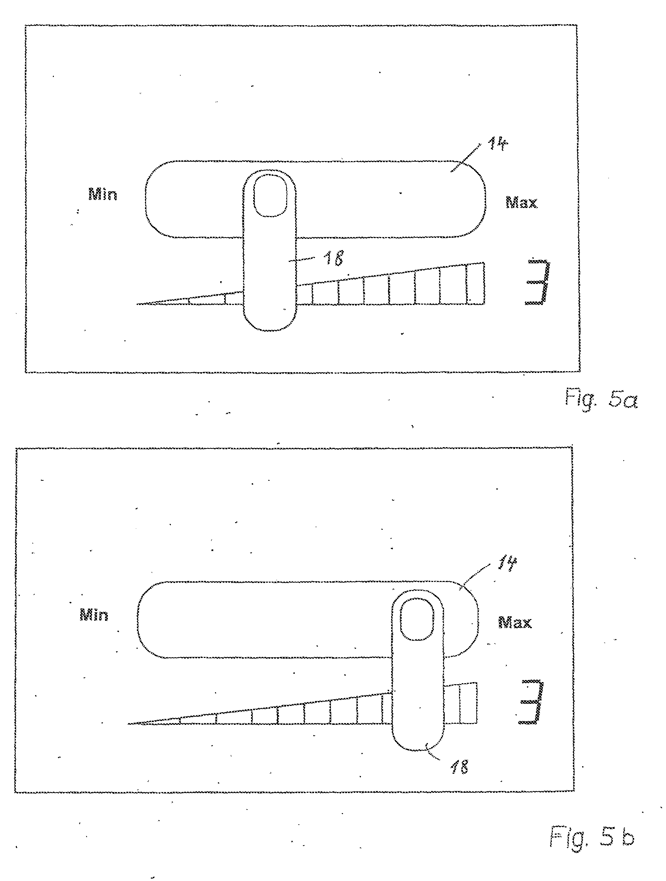

Es ist möglich, durch Betätigung eines bestimmten Bereiches der Betätigungsfläche 14 direkt eine Kochstufe anzuwählen, die diesem Bereich entspricht. Ist z. B die maximale Kochstufe, die eingestellt werden kann, "9" und es wird die Betätigungsfläche 14 im ersten Drittel berührt, so wird die Kochstufe "3" eingestellt. Diesen Vorgang der direkten Anwahl der Kochstufe "3" zeigt Figur 5a.

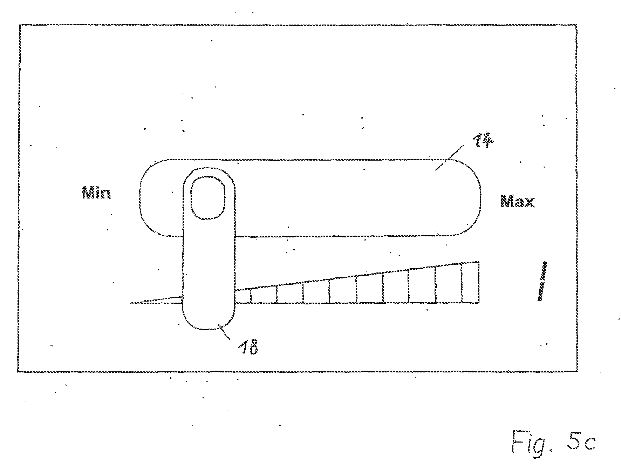

Es ist aber auch möglich, durch Überstreichen der Betätigungsfläche 14 die Kochstufe kontinuierlich zu verändern. Dabei bewirkt z.B. ein Überstreichen von links nach rechts eine Erhöhung und ein Überstreifen von rechts nach links eine Erniedrigung der eingestellten Kochstufe. Dabei muss der Start des Fingers 18 auf der Betätigungsfläche 14 nicht der gerade eingestellten Kochstufe entsprechen. Eine Fingerbewegung nach links zur Erniedrigung der Kochstufe ist beispielhaft in Figur 5b und Figur 5c dargestellt.

Auch ist es hierdurch möglich, die Kochstufe "0" anzuwählen, ohne die Betätigungsfläche 14 bis zur linken Begrenzungsfläche MIN zu überstreichen.

Die AUS-Position muss aus Gründen der Betriebssicherheit genau gekennzeichnet werden. Diese Kennzeichnung kann in der Betätigungsfläche 14 z.B. dadurch erfolgen, dass der linke Rand des Betätigungsfelds 14 durch ein AUS-Symbol hervorgehoben wird.

Durch eine Auswertung der Geschwindigkeit, mit der die Betätigungsfläche 14 überstrichen wird, ist es möglich, eine Änderung der Kochstufe schneller erfolgen zu lassen. Zum Beispiel kann eine schnelle Betätigung von rechts nach links als Panikreaktion gedeutet werden, weil das Kochgut überkocht oder anbrennt, und die Kochstufe wird entsprechend schnell erniedrigt. Andererseits kann ein langsames Überstreichen der Betätigungsfläche 14 als ein genaues Anwählen einer Kochstufe gedeutet werden und die Kochstufen wechseln entsprechend langsamer.

### Abkürzungen und Bezugsziffern

- IR: Infrarot
- N1: Anzahl der IR-Fototransistoren 4'
- N2: Anzahl der IR-Sendedioden 6
- α: Winkelstellung eines IR-Sensors 2 relativ zur Bedienlinie 16
- 2: IR-Sensoren
- 4: IR-Fototransistoren
- 6: IR-Sendedioden
- 8: Gehäuse (Lichtleitsockel 10 oder Kunststoffteil 12)
- 10: Lichtleitsockel
- 12: Kunststoffteil
- 14: Betätigungsfeld
- 16: Bedienlinie
- 18: Finger

## Patentansprüche

1. Kochfeldsteuerung zur Einstellung einer Kochstufe mit einer Mehrzahl von Infrarot (IR)-Sensoren (2) auf einer Bedienlinie (16) und mit einer längs der Bedienlinie (16) liegenden Betätigungsfläche (14), **dadurch gekennzeichnet, dass** eine Mehrzahl (N1) von IR-Fototransistoren (4) auf der Bedienlinie (16) für eine pseudo-kontinuierliche Bedienung nach Art eines Schiebereglers angeordnet sind, bei welcher Bedienung der Start eines Fingers (18) auf der Betätigungsfläche (14) nicht der gerade eingestellten Kochstufe entsprechen muss, und ferner **dadurch gekennzeichnet, dass** eine gleichgroße Anzahl (N2) von IR-Sendedioden (6) neben der Bedienlinie (16) in der Nachbarschaft der IR-Fototransistoren (4) so angeordnet sind, dass je ein IR-Fototransistor (4) und je eine Sendediode (6) ein Paar (2) mit jeweils gleicher Ausrichtung (α) relativ zu der Bedienlinie (16) bilden.

2. Kochfeldsteuerung nach Anspruch 1, **dadurch gekennzeichnet, dass** jeweils ein IR-Fototransistor (4) und zwei IR-Sendedioden (6) ein Tripel bilden, wobei die zwei IR-Sendedioden (6) auf je einer Seite des IR-Fototransistors (4) angeordnet sind.

3. Kochfeldsteuerung nach Anspruch 1 oder 2, **dadurch gekennzeichnet, dass** die Ausrichtung (α) relativ zur Bedienlinie (16) etwa 90° (α≈ 90) beträgt.

4. Kochfeldsteuerung nach Anspruch 1 oder 2, **dadurch gekennzeichnet, dass** die Ausrichtung (α) relativ zur Bedienlinie (16) etwa 95° bis 120° (α≈ 95 °bis 120 °) beträgt.

5. Kochfeldsteuerung nach einem der Ansprüche 1 bis 4, **dadurch gekennzeichnet, dass** die Bedienlinie (16) eine Gerade ist.

6. Kochfeldsteuerung nach einem der Ansprüche 1 bis 4, **dadurch gekennzeichnet, dass** die Bedienlinie (16) einen Kreisbogen beschreibt.

7. Kochfeldsteuerung nach einem der Ansprüche 1 bis 4, **dadurch gekennzeichnet, dass** die Bedienlinie (16) eine gekrümmte oder geschwungene Bahn beschreibt.

8. Kochfeldsteuerung nach einem der Ansprüche 1 bis 7, **dadurch gekennzeichnet, dass** die IR-Fototransistoren (4) und die IR-Sendedioden (6) in einem Gehäuse (8); Lichtleitsockel (10); Kunststoffteil (12) angeordnet sind.
